# EUROPEAN PATENT SPECIFICATION

(11) **EP 4 381 240 B1**
(45) Date of publication and mention of the grant of the patent: **04.03.2026**
(21) Application number: 21952674.6
(22) Date of filing: 04.11.2021
(51) Int. Cl.: H01L 23/467, H01L 23/367

(54) **ONE-PIECE FORMED METAL HEAT DISSIPATION PLATE AND HEAT DISSIPATION DEVICE HAVING SAME**
EINTEILIGE GEFORMTE METALLWÄRMEABLEITUNGSPLATTE UND WÄRMEABLEITUNGSVORRICHTUNG DAMIT
PLAQUE MÉTALLIQUE DE DISSIPATION DE CHALEUR FORMÉE D'UNE SEULE PIÈCE ET DISPOSITIF DE DISSIPATION DE CHALEUR LA COMPRENANT

(30) Priority: 06.08.2021 TW 110129196
(43) Date of publication of application: 12.06.2024
(73) Proprietor: Chen, Kuei-Fang, Toufen City, Miaoli County, 351010 (TW); Chen, Shyi Yuan, Diamond Bar, California 91765 (US)
(72) Inventor: Chen, Kuei-Fang, Toufen City, Miaoli County, 351010 (TW); Chen, Shyi Yuan, Diamond Bar, California 91765 (US)
(74) Representative: Petraz, Gilberto Luigi
(86) International application number: PCT/IB2021/060226
(87) International publication number: WO 2023/012509

(56) References cited:
- CN-U- 212 910 510
- JP-A- 2005 051 232
- TW-A- 200 706 822
- US-A- 5 653 285
- US-A1- 2014 345 834
- ZHU ZHANGYU, LI JUAN, PENG HAO, LIU DONGREN: "Nature-Inspired Structures Applied in Heat Transfer Enhancement and Drag Reduction", MICROMACHINES, vol. 12, no. 6, 8 January 2022 (2022-01-08), pages 656, XP093033868, DOI: 10.3390/mi12060656

## Description

### CROSS REFERENCE TO RELATED APPLICATIONS

The present application claims the priority of Taiwan Patent Application No. 110129196, filed with the National Intellectual Property Administration on August 06, 2021, titled "ONE-PIECE FORMED METAL HEAT DISSIPATION PLATE AND HEAT DISSIPATION DEVICE HAVING SAME", which is incorporated by reference in the present application in its entirety.

### Field of Disclosure

The present invention provides a heat dissipation structure. The heat dissipation structure particularly refers to a one-piece formed metal heat dissipation plate and a heat dissipation device using the same, in which more wavy portions are formed in a same unit area to improve heat dissipation.

### Description of Related Art

In order to quickly remove heat generated by a heat dissipation source, conventional heat dissipation structures comprise components such as water coolers, heat pipes, fans, or fins. However, if the above-mentioned multiple components are not well connected to each other, heat dissipation effects are compromised. In solution, there is a conventional heat dissipation device provided on the market, which is one-piece formed and composed of a heat dissipation plate and a plurality of heat dissipation strips. The heat dissipation plate is made of a metal material, and the heat dissipation strips are cut from the heat dissipation plate and then the heat dissipation strips are stamped (also known as pressed) to extend and protrude from one side of the heat dissipation plate. Accordingly, production costs are reduced, and a heat dissipation area of the heat dissipation plate is increased.

US5,653,285A, TW200706822A, and JP2005/051232A disclose conventional heat sinks with heat dissipation strips having wavy portions.

However, conventional one-piece formed heat dissipation devices have some shortcomings. The main reasons are as follows: First, when the heat dissipation plate is stamped to form the heat dissipation strips, a stamping stress is concentrated at connection positions between the heat dissipation plate and the heat dissipation strips. These connection positions are often too thin and prone to break, which not only easily damages the heat dissipation strips, but also limits an extended length of the heat dissipation strip. As a result, the heat dissipation area cannot be increased a lot. Secondly, because the heat dissipation strips on the heat dissipation plate are disposed at intervals and arranged according to height, such a structural design not only is difficult to achieve mass production, but also causes deformation and warpage of the heat dissipation plate due to an uneven stamping stress resulting from a stamping process. Therefore, the existing heat dissipation structure cannot meet the market demand, and has the deficiency of insufficient heat dissipation.

In view of this, the inventor of the present invention focused on the above-mentioned problems in conventional techniques, and concentrated on research and scientific theory to solve these problems.

### SUMMARY

It is an objective of the present invention to provide a one-piece formed metal heat dissipation plate and a heat dissipation device having the same, which lowers an overall height, and can be used and installed in a small space (less restricted by a space). Moreover, by means of a heat dissipation strip with multiple wavy portions, the present invention has an increased surface heat dissipation area in a same unit area, which facilitates mass production and improves heat dissipation.

The present invention provides a one-piece formed metal heat dissipation plate, comprising: a substrate and a plurality of heat dissipation strips arranged along a longitudinal direction. The substrate comprises a first surface and a second surface arranged opposite to each other. Each of the heat dissipation strips comprises two connection ends connected to the first surface, at least two wavy portions between the two connection ends, and a plurality of concave-convex tooth portions formed on at least one side of at least one of the wavy portions. A cut slot is defined in the substrate corresponding to the at least two wavy portions of each of the heat dissipation strips, and the cut slot penetrates the first surface and the second surface.

According to one embodiment, each of the wavy portions comprises at least one wave crest portion and at least one wave trough portion connected to the adjacent wave crest portion, each wave crest portion is triangular-shaped or arc-shaped, and each wave trough portion is triangular-shaped or arc-shaped, or is a plane parallel to the first surface.

According to one embodiment, in each heat dissipation strip, a wave height is defined between the highest wave crest portion and the lowest wave trough portion of each of the at least two wavy portions, the wave heights gradually increase in the longitudinal direction, an amplitude of each wavy portion also gradually increases in the longitudinal direction, and a height difference is present between the lowest wave trough portion of each wavy portion and the first surface.

According to one embodiment, in each heat dissipation strip, a wave height is defined between the highest wave crest portion and the lowest wave trough portion of each of the at least two wavy portions, the wave heights are equal in the longitudinal direction, an amplitude of each wavy portion is also equal in the longitudinal direction, and a height difference is present between the lowest wave trough portion of each wavy portion and the first surface.

According to one embodiment, copper or copper alloy is disposed on the first surface and each of the heat dissipation strips, and the copper or the copper alloy is also disposed on each wavy portion having the concave-convex tooth portions and is located on a surface opposite to the concave-convex tooth portions.

According to one embodiment, the substrate and each heat dissipation strip are made of aluminum or aluminum alloy, and each of the concave-convex tooth portions is triangular-shaped, rectangular-shaped, arc-shaped, or a combination thereof.

The present invention further provides a heat dissipation device, comprising at least a one-piece formed metal heat dissipation plate and an electronic device installed on one side of the metal heat dissipation plate. The heat dissipation device comprises: a base and a plurality of heat dissipation strips. The base comprises a plurality of substrates, wherein each of the substrates comprises a first surface and a second surface arranged opposite to each other. Each of the heat dissipation strips comprises two connection ends connected to the first surface, at least two wavy portions arranged between the two connection ends, and a plurality of concave-convex tooth portions formed on at least one side of each of the at least two wavy portions. A cut slot is defined in the substrate corresponding to the at least two wavy portions, and the cut slot penetrates the first surface and the second surface.

According to one embodiment, the base further comprises a connection plate connecting the substrates, and the connection plate and the outermost two of the substrates together form a horseshoe shape.

According to one embodiment, the wavy portion comprises at least one wave crest portion and at least one wave trough portion, the wave crest portion is triangular-shaped or arc-shaped, and each wave trough is triangular-shaped or arc-shaped, or is a plane parallel to the first surface.

According to one embodiment, in each heat dissipation strip, a wave height is defined between the highest wave crest portion and the lowest wave trough portion of each of the at least two wavy portions, and the wave heights gradually increase in the longitudinal direction, so that an amplitude of each wavy portion also gradually increases in the longitudinal direction.

According to one embodiment, in each heat dissipation strip, a wave height is defined between the highest wave crest portion and the lowest wave trough portion of each of the at least two wavy portions, the wave heights are equal in the longitudinal direction, and an amplitude of each wavy portion is also equal in the longitudinal direction.

According to one embodiment, copper or copper alloy is disposed on the first surface and each of the heat dissipation strips, and the copper or the copper alloy is disposed on each wavy portion having the concave-convex tooth portions and is located on a surface opposite to the concave-convex tooth portions.

According to one embodiment, the base and each heat dissipation strip are made of aluminum or aluminum alloy, and each of the concave-convex tooth portions is triangular-shaped, rectangular-shaped, arc-shaped, or a combination thereof.

The present invention provides the one-piece formed metal heat dissipation plate and the heat dissipation device using the same. By having the low-height/high-density-arrangement wavy portions and the concave-convex tooth portions, the wavy portions have a low overall height, are many in number, and are easy to produce. As a result, a surface heat dissipation area in a same unit area is increased, so the surface heat dissipation area and heat dissipation can be effectively improved. Therefore, in the embodiment, the concave-convex tooth portions are used to spread a stamping stress originally concentrated on the two connection ends of the metal heat dissipation plate to the entire heat dissipation strip, so the wavy portions of the heat dissipation strip are more easily extended and deformed. In addition, the stamping stress generated by stamping can also be released by the cut slot having a longer length, so the stamping stress is not just concentrated on the two connection ends of the metal heat dissipation plate to cause deformation and warpage. Furthermore, the concave-convex tooth portions can improve extensibility of the wavy portions of each heat dissipation strip, and reduces a risk that the heat dissipation strip easily breaks during processing. Therefore, the metal heat dissipation plate of the present embodiment does not generate any waste and has low production costs. The one-piece formed metal heat dissipation plate with multiple wavy portions and multiple concave-convex tooth portions greatly increases the surface heat dissipation area to improve heat dissipation, and also facilitates mass production.

### BRIEF DESCRIPTION OF DRAWINGS

For ease of understanding the above content of the present invention, a detailed description is provided below with reference to preferable embodiments and in conjunction with the accompanying drawings.
FIG. 1A is a schematic view illustrating a one-piece formed metal heat dissipation plate according to a first embodiment of the present invention.
FIG. 1B is a schematic view illustrating the one-piece formed metal heat dissipation plate according to a second embodiment of the present invention.
FIG. 2 is a perspective view of a heat dissipation device of the present invention.
FIG. 3A is a side view of the heat dissipation device of the present invention.
FIG. 3B is another embodiment of FIG. 3A.
FIG. 4 is another side view of the heat dissipation device of the present invention.
FIG. 5 is a schematic view illustrating that an electronic device is installed on a connection plate according to the present invention.
FIG. 6 is a schematic view of the one-piece formed metal heat dissipation plate according to a third embodiment of the present invention.
FIG. 7 is a side view of FIG. 6.
FIG. 8 is another side view of FIG. 6.

### DETAILED DESCRIPTION OF EMBODIMENTS

Please refer to the accompanying drawings, in which same reference numerals/letters represent the same components or similar components, and working principles of the present disclosure are described using examples in a suitable environment. The following descriptions are provided with reference to specific embodiments of the present disclosure, and should not be construed as limiting other embodiments of the present disclosure that are not specified herein.

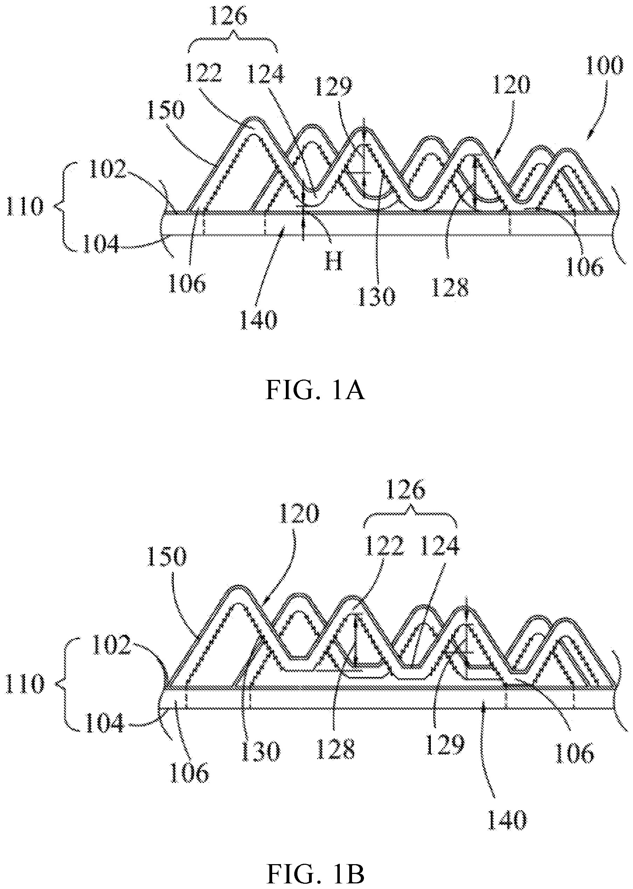

As shown in FIG. 1A and FIG. 1B, the present invention provides a one-piece formed metal heat dissipation plate 100, comprising: a substrate 110 and a plurality of heat dissipation strips 120 arranged in a longitudinal direction. The substrate 110 comprises a first surface 102 and a second surface 104 disposed opposite to each other. Each heat dissipation strip 120 comprises two connection ends 106 connected to the first surface 102, at least two wavy portions 126 arranged between the two connection ends 106, and a plurality of concave-convex tooth portions 130 formed on at least one side of at least one of the at least two wavy portions 126. A cut slot 140 is defined in the substrate 110 corresponding to the at least two wavy portions 126 of each heat dissipation strip 120, and the cut slot 140 penetrates the first surface 102 and the second surface 104.

Each of the wavy portions 126 comprises at least one wave crest portion 122 and at least one wave trough portion 124 connected to the adjacent wave crest portion 122. Each wave crest portion 122 is, for example, triangular-shaped or arc-shaped, or is of other suitable shape. The wave trough portion 124 is, for example, triangular-shaped or arc-shaped, or is a plane parallel to the first surface 102. In the embodiment shown in FIG. 1A, each wave crest portion 122 and each wave trough portion 124 is preferably triangular, which makes overall heat dissipation efficiency be about 80%. In the embodiment shown in FIG. 1B, the wave trough portion 124 preferably has a planar shape, so that the overall heat dissipation efficiency is as high as 90%. In other different embodiments, each wave crest portion 122 and each wave trough portion 124 can be arc-shaped, triangular-shaped, or a combination thereof as required for use in different environments.

In addition, in the present embodiment as shown in FIGs. 1A and 1B, in each heat dissipation strip 120, a wave height 128 between the highest wave crest portion and the lowest wave trough portion of each of the at least two wavy portions 126 gradually increases in the longitudinal direction. In other words, an amplitude 129 also gradually increases in the longitudinal direction. This effectively increases a heat dissipation area, and thereby can also improve heat dissipation. However, in other different embodiments, the wave height 128 of each of the at least two wavy portions 126 is designed to be equal in the longitudinal direction. That is, the amplitudes 129 are also equal in the longitudinal direction. Such configuration can also achieve good heat conduction and heat dissipation. It should be noted that the wave height 128 is preferably less than 20 millimeters (mm), so that the wavy portions 126 have a low overall height, and are many in number, and are easy to produce, thus increasing a surface heat dissipation area in a same unit area. There is a height difference H between the lowest wave trough portion 124 of the wavy portion 126 and the first surface 102, and the wave trough portion 124 is in a range of, for example, 1 mm to 10 mm. The height difference H can be designed to be a fixed value or gradually increase in the longitudinal direction, and configuration may vary as required.

A material of the substrate 110 and each heat dissipation strip 126 comprises aluminum or aluminum alloy, and each concave-convex tooth portion 130 is triangular-shaped, rectangular-shaped, or arc-shaped, or a combination thereof. Each concave-convex tooth portion 130 is preferably triangular-shaped. Because it is not easy for heat to stay at a tip of the triangle, the heat can be removed more quickly, and thus the heat dissipation is improved. In other different embodiments, each concave-convex tooth portion 130 can also be arc-shaped or of other suitable shape, and the present application is not limited in this regard. In the embodiment of FIG. 1A and FIG. 1B, copper 150 or copper alloy is disposed on the first surface 102 and each heat dissipation strip 126 by coating, electroplating, or other suitable methods. Thermal conductivity of the copper 150 is twice thermal conductivity of aluminum. In the present embodiment, thermal conductivity and heat dissipation can be improved by means of the copper 150 or the copper alloy. Specifically, the copper 150 or the copper alloy is preferably disposed on each wavy portion 126 having the concave-convex tooth portions 130 and is located on a surface opposite to the concave-convex tooth portions 130. However, in other different embodiments, the copper 150 or the copper alloy can also be disposed on the first surface 102 and the second surface 104 at the same time, and configuration may vary as required.

In the embodiment shown in FIG. 1A and FIG. 1B, a main material of the whole structure of the present invention is preferably pure aluminum or aluminum alloy, and at least one layer of pure copper 150 or two layers of the copper alloy are arranged on the structure. In other different embodiments, various other metals or alloys thereof can even be disposed on the pure copper 150 or the copper alloy, or two-layer composite metal materials (such as copper and aluminum composite materials) can be disposed on the pure copper 150 or the copper alloy to form two layers or three layers on the heat dissipation strip 120. A thickness of each layer varies according to actual application or use and according to heat dissipation conditions, and the present application is not limited in this regard. It should be noted that the afore-mentioned composite material can be an intermetallic layer consisting of two or more metals fused together. The three layers formed on the heat dissipation strip 120 are formed by various metals or alloys thereof superimposed on each other or fused together, and the present application is not limited in this regard. The above-mentioned other pure metals or alloys thereof comprise, but are not limited to, nickel, tin, zinc, silver, gold, iron, stainless steel, titanium, tungsten, beryllium, and bismuth.

A method of forming the heat dissipation strips 120 is described below. The concave-convex teeth portions 130 are formed on each wavy portion 126 of each heat dissipation strip 120 by, for example, stamping. The concave-convex tooth portions 130 in FIG. 1A are continuous or discontinuous on a surface of the wavy portion 126. However, the concave-convex tooth portions 130 in FIG. 1B on the wave trough portion 124 of each wavy portion 126 have to be flattened by another stamping process to form a flat surface. In detail, after the concave-convex tooth portions 130 are formed, each heat dissipation strip 120 is stamped again, so that each heat dissipation strip 120 forms the at least two wavy portions 126 which extend out of any one surface of the metal heat dissipation plate 100. For example, the at least two wavy portions 126 of each heat dissipation strip 120 extend out of the first surface 102 to form the cut slot 140 corresponding to the at least two wavy portions 126. The at least two wavy portions 126 shown in the present embodiment preferably comprise three wave crest portions 122 and two wave trough portions 124; however, the present application is not limited in this regard.

Through the low-height and high-density-arrangement wavy portions 126 and the concave-convex tooth portions 130, the surface heat dissipation area of each heat dissipation strip 120 can be increased, so that in the same unit area, the surface heat dissipation area is increased, and heat dissipation is improved. Therefore, in the present embodiment, the concave-convex tooth portions 130 are used to spread the stamping stress originally concentrated on the two connection ends 106 of the metal heat dissipation plate 100 to the entire heat dissipation strip 120, so the wavy portions 126 of the heat dissipation strip 120 are more easily extended and deformed. In addition, the stamping stress generated by stamping can also be released from the cut slot 140 having a longer length, so the stamping stress is not just concentrated on the two connection ends 106 of the metal heat dissipation plate 100 to cause deformation and warpage. Furthermore, the concave-convex tooth portions 130 can improve extensibility of the wavy portions 126 of each heat dissipation strip 120, and reduces a risk that the heat dissipation strip 120 easily breaks during processing. Therefore, the metal heat dissipation plate 100 of the present embodiment does not generate any waste and has low production costs. The one-piece formed metal heat dissipation plate 100 with multiple wavy portions 126 and multiple concave-convex tooth portions 130 greatly increases the surface heat dissipation area to improve heat dissipation, and also facilitates mass production.

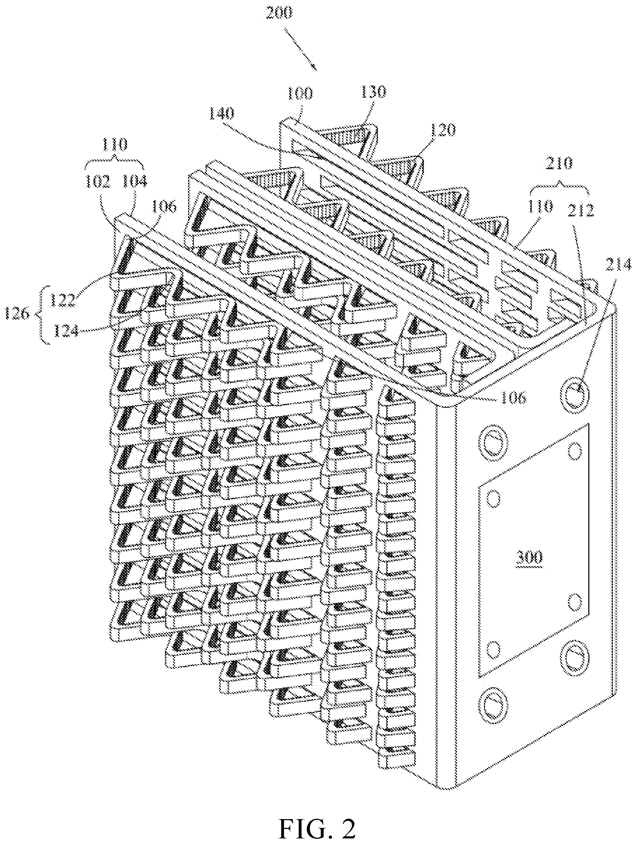

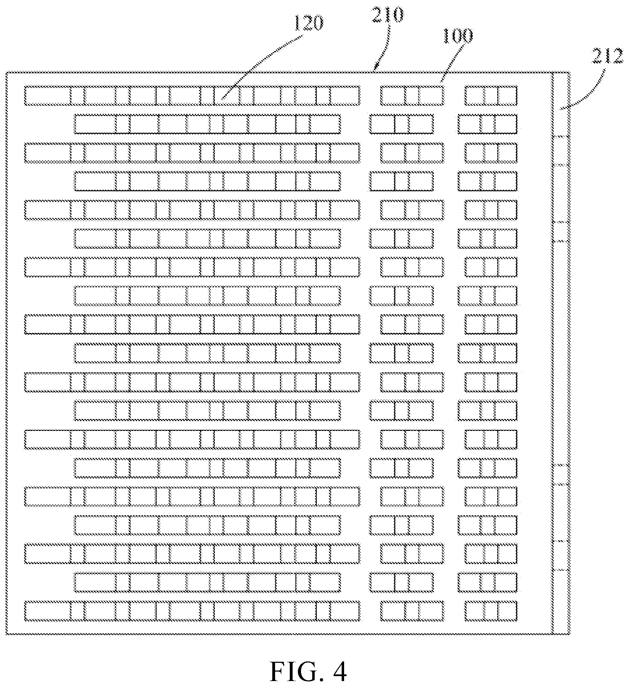

Please refer to FIGs. 2 to 5 together. The present invention also provides a heat dissipation device 200, which comprises at least a one-piece formed metal heat dissipation plate 100 and an electronic device 300 installed on one side of the metal heat dissipation plate 100. The electronic device 300 referred to here can be applied to all industries related to heat conduction, heat convection, heat radiation, and the like. For example, the electronic device 300 can be used in central processing units (CPU), graphics processing units (GPU), network processing units (NPU), and other electronic products. Alternatively, the electronic device 300 can be used in heat exchangers or heat exchange systems for semiconductor heat sinks, solar cells, car batteries, and power plants to improve heat dissipation and energy efficiency. The heat dissipation device 200 comprises a base 210 and a plurality of heat dissipation strips 120 arranged along a longitudinal direction. The base 210 comprises a plurality of substrates 110, and each substrate 110 comprises a first surface 102 and a second surface 104 opposite to each other. Each heat dissipation strip 120 comprises two connection ends 106 connected to the first surface 102, at least two wavy portions 126 between the two connection ends 106, and a plurality of concave-convex tooth portions 130 formed on at least one side of at least one of the at least two wavy portions 126. A cut slot 140 is defined in the substrate 110 corresponding to the at least two wavy portions 126 of each heat dissipation strip 120, and the cut slot 140 penetrates the first surface 102 and the second surface 104.

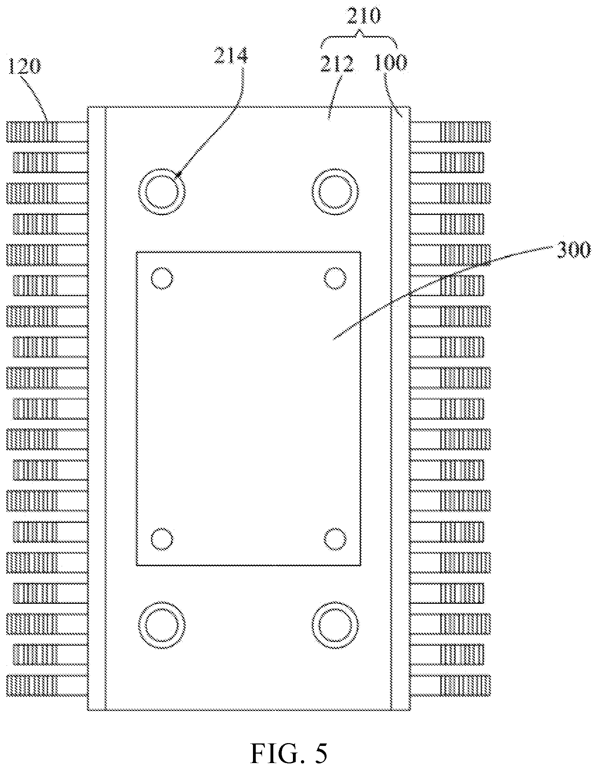

In the embodiment shown in FIG. 2 and FIG. 5, the base 210 further comprises a connection plate 212 connecting the substrates 110, and the electronic device 300 is can be securely mounted on one side of the connection plate 212 by means of screw connection elements (e.g., screws, not illustrated) and the assembly holes 214. The connection plate 212 and the outermost two of the substrates 110 together form a horseshoe shape (U-shaped). However, in other different embodiments, the base 210 can also be made into a rectangle, a disc shape, or other appropriate shape, depending on requirements or environments. When the electronic device 300 generates heat during operation, the connection plate 212 of the heat dissipation device 200 and the heat dissipation strips 120 connected to the heat dissipating plates 100 quickly transfer and remove heat, so as to achieve heat dissipation. Regarding a specific structure, a manufacturing method, and other detailed features of each metal heat dissipation plate 100 of the heat dissipation device 200, please refer to the foregoing embodiments, and a detailed description is not repeated here.

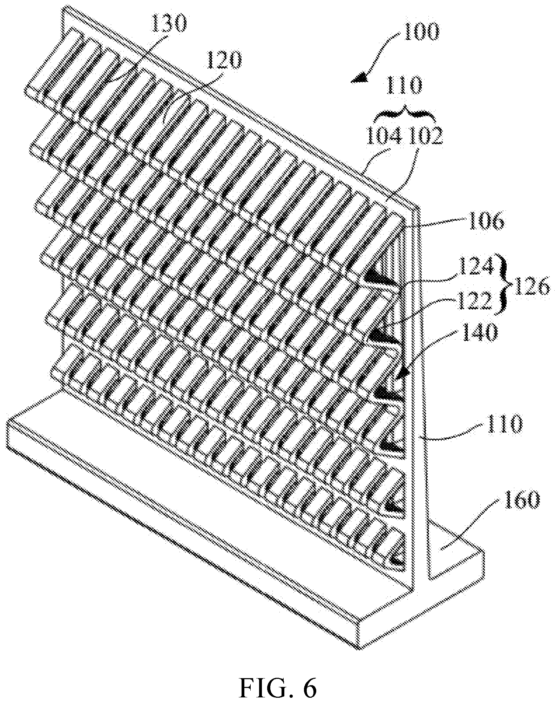

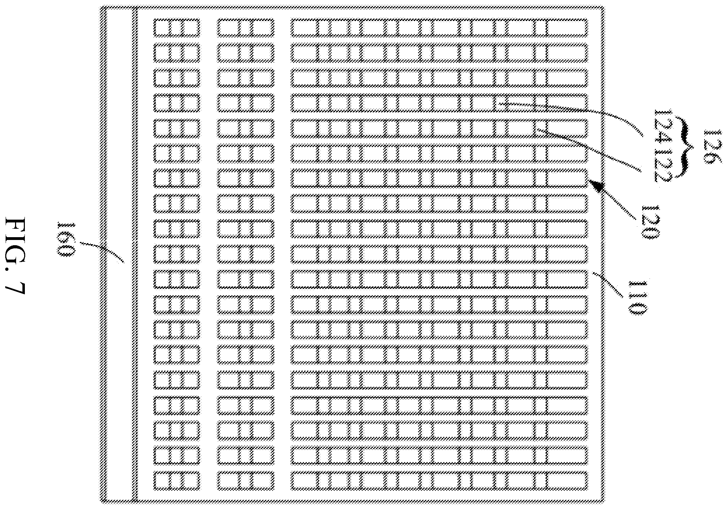

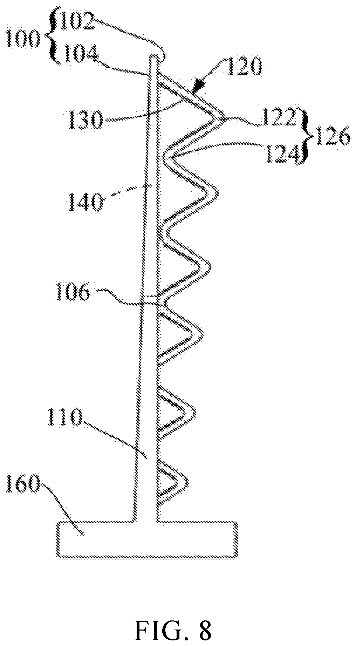

Please refer to FIGs. 6 to 8 together, which are a perspective view and a side view of the one-piece formed metal heat dissipation plate 100 of the present invention. A main difference between the present embodiment and the above-mentioned embodiments is that the present embodiment has only one substrate 100, one end of the substrate 110 is connected to a support plate 160, the support plate 160 and the substrate 110 are perpendicular to each other, and then the support plate 160 is fixed to the base 210 of the heat dissipation device 200. A thickness of the substrate 110 gradually becomes thinner in a direction away from the support plate 160. Similarly, this allows heat to be removed more quickly because it is difficult for heat to stay at a tip. As a result, the present application achieves better heat dissipation. Regarding a specific structure, a manufacturing method, and other detailed features of the metal heat dissipation plate 100, reference can be made to the foregoing embodiments, and a detailed description is omitted here for brevity.

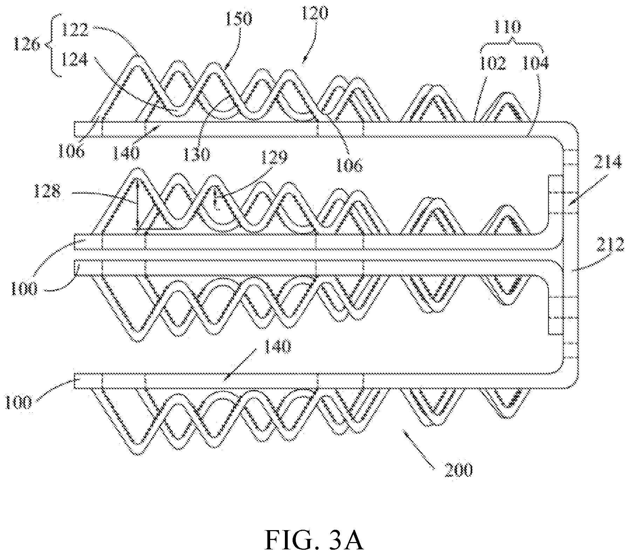

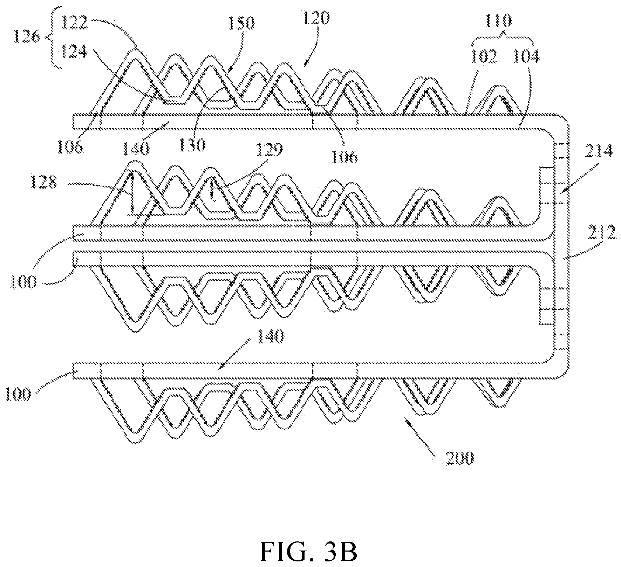

The heat dissipation device 200 of the present embodiment is provided with multiple metal heat dissipation plates 100. Each metal heat dissipation plate 100 is provided with a plurality of wavy portions 126 arranged at intervals. According to size or requirements, each metal heat dissipation plate 100 connected to the connection plate 212 can be provided with only one heat dissipation strip 120. As shown in the embodiments of FIGs. 2 and 3A-3B, the wave heights 128 of each heat dissipation strip 120 preferably gradually increase toward an opening (not labeled) of the base 210, so the surface heat dissipation area per unit area also gradually increases, thereby improving the heat dissipation and heat dissipation efficiency. Through experiments, it is found that, under the same conditions, data is 9503 pts while the heat dissipation device 200 is used to test a CPU (for example: Ryzen 5 3600XT), which increases the heat dissipation by 20% compared to conventional techniques. Therefore, by means of the greatly increased surface heat dissipation area, and the heat dissipation device 200 surely can improve the heat dissipation.

Through the low-height/high-density-arrangement wavy portions 126 and the concave-convex tooth portions 130, the surface heat dissipation area of the heat dissipation strip 120 can be increased, so the surface heat dissipation area and the heat dissipation in the same unit area can be effectively increased. Therefore, in this embodiment, the concave-convex tooth portions 130 are used to spread the stamping stress originally concentrated on the two connection ends 106 of the metal heat dissipation plate 100 to the entire heat dissipation strip 120, so the wavy portions 126 of the heat dissipation strip 120 are more easily extended and deformed. In addition, the stamping stress generated by stamping can also be released by the cut slot 140 having a longer length, so the stamping stress is not just concentrated on the two connection ends 106 of the metal heat dissipation plate 100 to cause deformation and warpage. Furthermore, the concave-convex tooth portions 130 can improve extensibility of the wavy portions 126 of each heat dissipation strip 120, and reduces a risk that the heat dissipation strip 120 easily breaks during processing. Therefore, the metal heat dissipation plate 100 of the present embodiment does not generate any waste and has low production costs. The one-piece formed metal heat dissipation plate 100 with multiple wavy portions 126 and multiple concave-convex tooth portions 130 greatly increases the surface heat dissipation area to improve heat dissipation, and also facilitates mass production.

## Claims

1. A one-piece formed metal heat dissipation plate (100), wherein the one-piece formed metal heat dissipation plate (100) comprises:
a substrate (110) comprising a first surface (102) and a second surface (104) arranged opposite to each other; and
a plurality of heat dissipation strips (120) arranged along a longitudinal direction, wherein each of the heat dissipation strips (120) comprises two connection ends (106) connected to the first surface (102), at least two wavy portions (126) arranged between the two connection ends (106), and a plurality of concave-convex tooth portions (130) formed on at least one side of at least one of the wavy portions (126); and a cut slot (140) is defined in the substrate (110) corresponding to the at least two wavy portions (126) of each of the heat dissipation strips (120), and the cut slot (140) penetrates the first surface (102) and the second surface (104).

2. The one-piece formed metal heat dissipation plate (100) according to claim 1, **characterized in that** each of the wavy portions (126) comprises at least one wave crest portion (122) and at least one wave trough portion (124) connected to the adjacent wave crest portion (122), each wave crest portion (122) is triangular-shaped or arc-shaped, and each wave trough portion (124) is triangular-shaped or arc-shaped, or is a plane parallel to the first surface (102).

3. The one-piece formed metal heat dissipation plate (100) according to claim 2, **characterized in that** in each heat dissipation strip (120), a wave height is defined between the highest wave crest portion (122) and the lowest wave trough portion (124) of each of the at least two wavy portions (126), the wave heights gradually increase in the longitudinal direction, an amplitude of each wavy portion (126) also gradually increases in the longitudinal direction, and a height difference is present between the lowest wave trough portion (124) of each wavy portion (126) and the first surface (102).

4. The one-piece formed metal heat dissipation plate (100) of claim 2, **characterized in that** in each heat dissipation strip (120), a wave height is defined between the highest wave crest portion (122) and the lowest wave trough portion (124) of each of the at least two wavy portions (126), the wave heights are equal in the longitudinal direction, an amplitude of each wavy portion (126) is also equal in the longitudinal direction, and a height difference is present between the lowest wave trough portion (124) of each wavy portion (126) and the first surface (102).

5. The one-piece formed metal heat dissipation plate (100) according to claim 1, **characterized in that** copper or copper alloy is disposed on the first surface (102) and each of the heat dissipation strips (120), and the copper or the copper alloy is also disposed on each wavy portion having the concave-convex tooth portions (130) and is located on a surface opposite to the concave-convex tooth portions (130).

6. The one-piece formed metal heat dissipation plate (100) according to claim 1, **characterized in that** materials of the substrate (110) and each heat dissipation strip (120) are aluminum or aluminum alloy, and each of the concave-convex tooth portions (130) is triangular, rectangular, arc-shaped, or a combination thereof.

7. A heat dissipation device (200), wherein the heat dissipation device (200) comprises at least a one-piece formed metal heat dissipation plate (100) and an electronic device (300) installed on one side of the metal heat dissipation plate (100), wherein the heat dissipation device (100) comprises:
a base (210) comprising a plurality of substrates (110), wherein each of the substrates (110) comprises a first surface (102) and a second surface (104) arranged opposite to each other; and
a plurality of heat dissipation strips (120) arranged in a longitudinal direction, wherein each of the heat dissipation strips (120) comprises two connection ends (106) connected to the first surface (102), at least two wavy portions (126) arranged between the two connection ends (106), and a plurality of concave-convex tooth portions (130) formed on at least one side of each of the at least two wavy portions (126); a cut slot (140) is defined in the substrate (110) corresponding to the at least two wavy portions (126), and the cut slot (140) penetrates the first surface (102) and the second surface (104).

8. The heat dissipation device (200) according to claim 7, **characterized in that** the base (210) further comprises a connection plate (212) connecting the substrates (110), and the connection plate (212) and the outermost two of the substrates (110) together form a horseshoe shape.

9. The heat dissipation device (200) according to claim 7, **characterized in that** the wavy portion (126) comprises at least one wave crest portion (122) and at least one wave trough portion (124), the wave crest portion (122) is triangular-shaped or arc-shaped, and each wave trough (124) is triangular-shaped or arc-shaped, or is a plane parallel to the first surface (102).

10. The heat dissipation device (200) according to claim 9, **characterized in that** in each heat dissipation strip (120), a wave height is defined between the highest wave crest portion (122) and the lowest wave trough portion (124) of each of the at least two wavy portions (126), and the wave heights gradually increase in the longitudinal direction, so that an amplitude of each wavy portion (126) also gradually increases in the longitudinal direction.

11. The heat dissipation device (200) according to claim 9, **characterized in that** in each heat dissipation strip (120), a wave height is defined between the highest wave crest portion (122) and the lowest wave trough portion (124) of each of the at least two wavy portions (126), the wave heights are equal in the longitudinal direction, and an amplitude of each wavy portion (126) is also equal in the longitudinal direction.

12. The heat dissipation device (200) according to claim 7, **characterized in that** copper or copper alloy is disposed on the first surface (102) and each of the heat dissipation strips (120), and the copper or the copper alloy is disposed on each wavy portion (126) having the concave-convex tooth portions (130) and is located on a surface opposite to the concave-convex tooth portions (130).

13. The heat dissipation device (200) according to claim 9, **characterized in that** the base (210) and each heat dissipation strip (120) are made of aluminum or aluminum alloy, and each of the concave-convex tooth portions (130) is triangular-shaped, rectangular-shaped, arc-shaped, or a combination thereof.

## Patentansprüche

1. Einteilige geformte Metallwärmeableitungsplatte (100), worin die einteilige geformte Metallwärmeableitungsplatte (100) umfasst:
ein Substrat (110) umfassend eine erste Fläche (102) und eine zweite Fläche (104), die einander gegenüberliegend angeordnet sind; und
eine Vielzahl von Wärmeableitungsstreifen (120), die entlang einer Längsrichtung angeordnet sind, worin jeder von den Wärmeableitungsstreifen (120) zwei Verbindungsenden (106), die mit der ersten Fläche (102) verbunden sind, zumindest zwei wellige Abschnitte (126), die zwischen den zwei Verbindungsenden (106) angeordnet sind, und eine Vielzahl von konkav-konvexen Zahnabschnitten (130), die auf zumindest einer Seite von zumindest einem der welligen Abschnitte (126) ausgebildet sind, umfasst; und ein geschnittener Schlitz (140) im Substrat (110) definiert ist, der den zumindest zwei welligen Abschnitten (126) von jedem der Wärmeableitungsstreifen (120) entspricht, und der geschnittene Schlitz (140) die erste Fläche (102) und die zweite Fläche (104) durchdringt.

2. Einteilige geformte Metallwärmeableitungsplatte (100) nach Anspruch 1, **dadurch gekennzeichnet, dass** jeder der welligen Abschnitte (126) zumindest einen Wellenbergabschnitt (122) und zumindest einen Wellentalabschnitt (124), der mit dem angrenzenden Wellenbergabschnitt (122) verbunden ist, umfasst, jeder Wellenbergabschnitt (122) dreiecksförmig oder bogenförmig ist, und jeder Wellentalabschnitt (124) dreiecksförmig oder bogenförmig ist, oder eine Ebene ist, die zur ersten Fläche (102) parallel ist.

3. Einteilige geformte Metallwärmeableitungsplatte (100) nach Anspruch 2, **dadurch gekennzeichnet, dass** in jedem Wärmeableitungsstreifen (120) eine Wellenhöhe zwischen dem höchsten Wellenbergabschnitt (122) und dem niedrigsten Wellentalabschnitt (124) von jedem der zumindest zwei welligen Abschnitte (126) definiert ist, die Wellenhöhen in der Längsrichtung allmählich zunehmen, eine Amplitude jedes welligen Abschnitts (126) in der Längsrichtung ebenfalls allmählich zunimmt, und ein Höhenunterschied zwischen dem niedrigsten Wellentalabschnitt (124) jedes welligen Abschnitts (126) und der ersten Fläche (102) vorhanden ist.

4. Einteilige geformte Metallwärmeableitungsplatte (100) nach Anspruch 2, **dadurch gekennzeichnet, dass** in jedem Wärmeableitungsstreifen (120) eine Wellenhöhe zwischen dem höchsten Wellenbergabschnitt (122) und dem niedrigsten Wellentalabschnitt (124) von jedem der zumindest zwei welligen Abschnitte (126) definiert ist, die Wellenhöhen in der Längsrichtung gleich sind, eine Amplitude jedes welligen Abschnitts (126) in der Längsrichtung ebenfalls gleich ist, und ein Höhenunterschied zwischen dem niedrigsten Wellentalabschnitt (124) jedes welligen Abschnitts (126) und der ersten Fläche (102) vorhanden ist.

5. Einteilige geformte Metallwärmeableitungsplatte (100) nach Anspruch 1, **dadurch gekennzeichnet, dass** Kupfer oder Kupferlegierung auf der ersten Fläche (102) und auf jedem der Wärmeableitungsstreifen (120) angeordnet ist, und das Kupfer oder die Kupferlegierung auch an jedem welligen Abschnitt angeordnet ist, der die konkav-konvexen Zahnabschnitte (130) hat und auf einer Fläche, die den konkav-konvexen Zahnabschnitten (130) gegenüberliegend ist, angeordnet ist.

6. Einteilige geformte Metallwärmeableitungsplatte (100) nach Anspruch 1, **dadurch gekennzeichnet, dass** Materialien des Substrats (110) und jeder Wärmeableitungsstreifen (120) aus Aluminium oder Aluminiumlegierung bestehen, und jeder von den konkav-konvexen Zahnabschnitten (130) dreiecksförmig, rechteckig, bogenförmig oder eine Kombination davon ist.

7. Wärmeableitungsvorrichtung (200), worin die Wärmeableitungsvorrichtung (200) zumindest eine einteilige geformte Metallwärmeableitungsplatte (100) und eine elektronische Vorrichtung (300), die auf einer Seite der Metallwärmeableitungsplatte (100) installiert ist, umfasst, worin die Wärmeableitungsvorrichtung (100) umfasst:
eine Basis (210), die eine Vielzahl von Substraten (110) umfasst, worin jedes der Substrate (110) eine erste Fläche (102) und eine zweite Fläche (104) umfasst, die einander gegenüberliegend angeordnet sind; und
eine Vielzahl von Wärmeableitungsstreifen (120), die entlang einer Längsrichtung angeordnet sind, worin jeder von den Wärmeableitungsstreifen (120) zwei Verbindungsenden (106), die mit der ersten Fläche (102) verbunden sind, zumindest zwei wellige Abschnitte (126), die zwischen den zwei Verbindungsenden (106) angeordnet sind, und eine Vielzahl von konkav-konvexen Zahnabschnitten (130), die auf zumindest einer Seite von jedem der zumindest zwei welligen Abschnitte (126) ausgebildet sind, umfasst; ein geschnittener Schlitz (140) im Substrat (110) definiert ist, der den zumindest zwei welligen Abschnitten (126) entspricht, und der geschnittene Schlitz (140) die erste Fläche (102) und die zweite Fläche (104) durchdringt.

8. Wärmeableitungsvorrichtung (200) nach Anspruch 7, **dadurch gekennzeichnet, dass** die Basis (210) ferner eine Verbindungsplatte (212) umfasst, die die Substrate (110) verbindet, und die Verbindungsplatte (212) und die äußersten zwei von den Substraten (110) zusammen eine Hufeisenform bilden.

9. Wärmeableitungsvorrichtung (200) nach Anspruch 7, **dadurch gekennzeichnet, dass** der wellige Abschnitt (126) zumindest einen Wellenbergabschnitt (122) und zumindest einen Wellentalabschnitt (124) umfasst, der Wellenbergabschnitt (122) dreiecksförmig oder bogenförmig ist, und jedes Wellental (124) dreiecksförmig oder bogenförmig ist, oder eine Ebene ist, die zur ersten Fläche (102) parallel ist.

10. Wärmeableitungsvorrichtung (200) nach Anspruch 9, **dadurch gekennzeichnet, dass** in jedem Wärmeableitungsstreifen (120) eine Wellenhöhe zwischen dem höchsten Wellenbergabschnitt (122) und dem niedrigsten Wellentalabschnitt (124) von jedem der zumindest zwei welligen Abschnitte (126) definiert ist, und die Wellenhöhen in der Längsrichtung allmählich zunehmen, so dass eine Amplitude jedes welligen Abschnitts (126) in der Längsrichtung ebenfalls allmählich zunimmt.

11. Wärmeableitungsvorrichtung (200) nach Anspruch 9, **dadurch gekennzeichnet, dass** in jedem Wärmeableitungsstreifen (120) eine Wellenhöhe zwischen dem höchsten Wellenbergabschnitt (122) und dem niedrigsten Wellentalabschnitt (124) von jedem der zumindest zwei welligen Abschnitte (126) definiert ist, die Wellenhöhen in der Längsrichtung gleich sind, und eine Amplitude jedes welligen Abschnitts (126) in der Längsrichtung ebenfalls gleich ist.

12. Wärmeableitungsvorrichtung (200) nach Anspruch 7, **dadurch gekennzeichnet, dass** Kupfer oder Kupferlegierung auf der ersten Fläche (102) und auf jedem der Wärmeableitungsstreifen (120) angeordnet ist, und das Kupfer oder die Kupferlegierung an jedem welligen Abschnitt (126) angeordnet ist, der die konkav-konvexen Zahnabschnitte (130) hat und auf einer Fläche, die den konkav-konvexen Zahnabschnitten (130) gegenüberliegend ist, angeordnet ist.

13. Wärmeableitungsvorrichtung (200) nach Anspruch 9, **dadurch gekennzeichnet, dass** die Basis (210) und jeder Wärmeableitungsstreifen (120) aus Aluminium oder Aluminiumlegierung hergestellt sind, und jeder von den konkav-konvexen Zahnabschnitten (130) dreiecksförmig, rechteckig, bogenförmig oder eine Kombination davon ist.

## Revendications

1. Plaque de dissipation de chaleur métallique formée d'une seule pièce (100), dans laquelle la plaque de dissipation de chaleur métallique formée d'une seule pièce (100) comprend :
un substrat (110), comprenant une première surface (102) et une seconde surface (104) disposées opposées l'une à l'autre ;
une pluralité de bandes de dissipation de chaleur (120) disposées le long d'une direction longitudinale, dans laquelle chacune des bandes de dissipation de chaleur (120) comprend deux extrémités de connexion (106) reliées à la première surface (102), au moins deux parties ondulées (126) disposées entre les deux extrémités de connexion (106), et une pluralité de parties de dents concaves-convexes (130) formées sur au moins un côté d'au moins une des parties ondulées (126) ; et une fente découpée (140) est définie dans le substrat (110) correspondant aux au moins deux parties ondulées (126) de chacune des bandes de dissipation thermique (120), et la fente découpée (140) pénètre dans la première surface (102) et la seconde surface (104).

2. Plaque de dissipation de chaleur métallique formée d'une seule pièce (100) selon la revendication 1, **caractérisée en ce que** chacune des parties ondulées (126) comprend au moins une partie de crête d'onde (122) et au moins une partie de creux d'onde (124) reliée à la partie de crête d'onde adjacente (122), chaque partie de crête d'onde (122) est de forme triangulaire ou en forme d'arc, et chaque partie de creux d'onde (124) est de forme triangulaire ou en forme d'arc, ou est un plan parallèle à la première surface (102).

3. Plaque de dissipation de chaleur métallique formée d'une seule pièce (100) selon la revendication 2, **caractérisée en ce que** dans chaque bande de dissipation de chaleur (120), une hauteur d'onde est définie entre la partie de crête d'onde la plus haute (122) et la partie de creux d'onde la plus basse (124) de chacune des au moins deux parties ondulées (126), les hauteurs d'onde augmentent progressivement dans la direction longitudinale, une amplitude de chaque partie ondulée (126) augmente également progressivement dans la direction longitudinale, et une différence de hauteur est présente entre la partie de creux d'onde la plus basse (124) de chaque partie ondulée (126) et la première surface (102).

4. Plaque de dissipation de chaleur métallique formée d'une seule pièce (100) selon la revendication 2, **caractérisée en ce que** dans chaque bande de dissipation de chaleur (120), une hauteur d'onde est définie entre la partie de crête d'onde la plus haute (122) et la partie de creux d'onde la plus basse (124) de chacune des au moins deux parties ondulées (126), les hauteurs d'onde sont égales dans la direction longitudinale, une amplitude de chaque partie ondulée (126) est également égale dans la direction longitudinale, et une différence de hauteur est présente entre la partie de creux d'onde la plus basse (124) de chaque partie ondulée (126) et la première surface (102).

5. Plaque de dissipation de chaleur métallique formée en une seule pièce (100) selon la revendication 1, **caractérisée en ce que** du cuivre ou un alliage de cuivre est disposé sur la première surface (102) et chacune des bandes de dissipation de chaleur (120), et le cuivre ou l'alliage de cuivre est également disposé sur chaque partie ondulée ayant les parties de dents concaves-convexes (130) et est situé sur une surface opposée aux parties de dents concaves-convexes (130).

6. Plaque de dissipation de chaleur métallique formée d'une seule pièce (100) selon la revendication 1, **caractérisée en ce que** les matériaux du substrat (110) et de chaque bande de dissipation de chaleur (120) sont de l'aluminium ou un alliage d'aluminium, et chacune des parties de dents concaves-convexes (130) est triangulaire, rectangulaire, en forme d'arc, ou une combinaison de celles-ci.

7. Dispositif de dissipation de chaleur (200), dans lequel le dispositif de dissipation de chaleur (200) comprend au moins une plaque de dissipation de chaleur métallique formée d'une seule pièce (100) et un dispositif électronique (300) installé sur un côté de la plaque de dissipation de chaleur métallique (100), dans lequel le dispositif de dissipation de chaleur (100) comprend :
une base (210) comprenant une pluralité de substrats (110), dans lequel chacun des substrats (110) comprend une première surface (102) et une seconde surface (104) disposées l'une en face de l'autre ; et
une pluralité de bandes de dissipation de chaleur (120) disposées dans une direction longitudinale, dans laquelle chacune des bandes de dissipation de chaleur (120) comprend deux extrémités de connexion (106) reliées à la première surface (102), au moins deux parties ondulées (126) disposées entre les deux extrémités de connexion (106), et une pluralité de parties de dents concaves-convexes (130) formées sur au moins un côté de chacune des au moins deux parties ondulées (126) ; une fente découpée (140) est définie dans le substrat (110) correspondant aux au moins deux parties ondulées (126), et la fente découpée (140) pénètre dans la première surface (102) et la seconde surface (104).

8. Dispositif de dissipation de chaleur (200) selon la revendication 7, **caractérisé en ce que** la base (210) comprend en outre une plaque de connexion (212) reliant les substrats (110), et la plaque de connexion (212) et les deux substrats les plus à l'extérieur (110) forment ensemble une forme de fer à cheval.

9. Dispositif de dissipation de chaleur (200) selon la revendication 7, **caractérisé en ce que** la partie ondulée (126) comprend au moins une partie de crête d'onde (122) et au moins une partie de creux d'onde (124), la partie de crête d'onde (122) est de forme triangulaire ou en forme d'arc, et chaque creux d'onde (124) est de forme triangulaire ou en forme d'arc, ou est un plan parallèle à la première surface (102).

10. Dispositif de dissipation de chaleur (200) selon la revendication 9, **caractérisé en ce que** dans chaque bande de dissipation de chaleur (120), une hauteur d'onde est définie entre la partie de crête d'onde la plus haute (122) et la partie de creux d'onde la plus basse (124) de chacune des au moins deux parties ondulées (126), et les hauteurs d'onde augmentent progressivement dans la direction longitudinale, de sorte qu'une amplitude de chaque partie ondulée (126) augmente également progressivement dans la direction longitudinale.

11. Dispositif de dissipation de chaleur (200) selon la revendication 9, **caractérisé en ce que** dans chaque bande de dissipation de chaleur (120), une hauteur d'onde est définie entre la partie de crête d'onde la plus haute (122) et la partie de creux d'onde la plus basse (124) de chacune des au moins deux parties ondulées (126), les hauteurs d'onde sont égales dans la direction longitudinale, et une amplitude de chaque partie ondulée (126) est également égale dans la direction longitudinale.

12. Dispositif de dissipation de chaleur (200) selon la revendication 7, **caractérisé en ce que** du cuivre ou un alliage de cuivre est disposé sur la première surface (102) et chacune des bandes de dissipation de chaleur (120), et le cuivre ou l'alliage de cuivre est disposé sur chaque partie ondulée (126) ayant les parties de dents concaves-convexes (130) et est situé sur une surface opposée aux parties de dents concaves-convexes (130).

13. Dispositif de dissipation de chaleur (200) selon la revendication 9, **caractérisé en ce que** la base (210) et chaque bande de dissipation de chaleur (120) sont faites d'aluminium ou d'alliage d'aluminium, et chacune des parties de dents concaves-convexes (130) est de forme triangulaire, rectangulaire, en forme d'arc, ou une combinaison de celles-ci.
